# EUROPÄISCHE PATENTSCHRIFT

(11) **EP 3 766 177 B1**
(45) Veröffentlichungstag und Bekanntmachung des Hinweises auf die Patenterteilung: **11.11.2026**
(21) Anmeldenummer: 19708514.5
(22) Anmeldetag: 01.03.2019
(51) Int. Cl.: H03K 17/16, H02M 1/38, H03K 17/0812, H03K 17/08

(54) **VERFAHREN UND VORRICHTUNG ZUM EINSTELLEN EINER TOTZEIT VON SCHALTELEMENTEN EINER HALBBRÜCKE, UND WECHSELRICHTER**
METHOD AND DEVICE FOR SETTING A DEAD TIME OF SWITCHING ELEMENTS OF A HALF BRIDGE, AND INVERTER
PROCÉDÉ ET DISPOSITIF DE RÉGLAGE D'UN TEMPS MORT D'ÉLÉMENTS DE COMMUTATION D'UN DEMI-PONT, ET ONDULEUR

(30) Priorität: 16.03.2018 DE 102018204017
(43) Veröffentlichungstag der Anmeldung: 20.01.2021
(73) Patentinhaber: Robert Bosch GmbH, 70442 Stuttgart (DE)
(72) Erfinder: GEYER, Hans, 70771 Leinfelden-Echterdingen (DE)
(86) Internationale Anmeldenummer: PCT/EP2019/055132
(87) Internationale Veröffentlichungsnummer: WO 2019/174931

(56) Entgegenhaltungen:
- DE-A1- 102012 006 009
- DE-B3- 102011 083 679
- US-A1- 2006 012 428

## Beschreibung

Die vorliegende Erfindung betrifft ein Verfahren und eine Vorrichtung zum Einstellen einer Totzeit zwischen dem Öffnen eines ersten Schaltelements einer Halbbrücke und dem Schließen eines zweiten Schaltelements der Halbbrücke eines Wechselrichters, welcher einer elektrischen Maschine eines Kraftfahrzeugs elektrische Energie bereitstellt. Weiter betrifft die Erfindung einen Wechselrichter, welcher einer elektrischen Maschine eines Kraftfahrzeugs elektrische Energie bereitstellt.

### Stand der Technik

Elektrische Maschinen von Antriebssystemen können über einen Wechselrichter mit Wechselspannung versorgt werden. Eine beispielhafte Ansteuerung eines Wechselrichters ist aus der Druckschrift DE 10 2011 081 173 A1 bekannt. Der Wechselrichter umfasst mehrere Halbbrücken, wobei die Anzahl der Halbbrücken der Anzahl der Phasen der elektrischen Maschine entspricht. Die Halbbrücken weisen jeweils zwei in Serie geschaltete Schaltelemente auf, wobei die Schaltelemente nicht gleichzeitig geschlossen werden dürfen, um einen Kurzschluss zu verhindern. Bei der Kommutierung muss zusätzlich darauf geachtet werden, dass nach dem Öffnen des ersten Schaltelements das zweite Schaltelement auch nicht sofort geschlossen wird. Aufgrund von sich verzögert aufbauenden elektromagnetischen Felder der Halbbrücken-Leistungshalbleiter entstünden andernfalls Quereinflüsse, welche zu einer unerwünschten Erwärmung der Halbbrücken-Leistungshalbleiter führen können. Aus diesem Grund bleiben während einer Totzeit nach dem Öffnen des ersten Schaltelements beide Schaltelemente geöffnet.

Um eine effektive Energieübertragung durch den Wechselrichter zu gewährleisten, ist es jedoch wünschenswert, die Totzeit möglichst knapp zu bemessen.

Die Druckschrift US 2006 / 012 428 A1 offenbart ein Verfahren zur Einstellung einer Totzeit einer Schaltverstärkereinheit eines D-Klasse Verstärkers.

Die Druckschriften DE 10 2011 083679 B3 und DE 10 2012 006009 A1 betreffen Verfahren zur Ermittlung der Temperatur eines Halbleiterschalters bzw. eines Halbleiterbauelements.

### Offenbarung der Erfindung

Die Erfindung stellt ein Verfahren zum Einstellen einer Totzeit zwischen dem Ausschalten bzw. Öffnen eines ersten Schaltelements einer Halbbrücke und dem Einschalten bzw. Schließen eines zweiten Schaltelements der Halbbrücke mit den Merkmalen des Patentanspruchs 1 bereit. Weiter stellt die Erfindung eine Vorrichtung zum Einstellen einer Totzeit zwischen dem Öffnen eines ersten Schaltelements einer Halbbrücke und dem Schließen eines zweiten Schaltelements der Halbbrücke mit den Merkmalen des Patentanspruchs 11 bereit. Die Erfindung stellt schließlich einen Wechselrichter mit den Merkmalen des Patentanspruchs 14 bereit.

Gemäß einem ersten Aspekt betrifft die Erfindung demnach ein Verfahren gemäß Anspruch 1 zum Einstellen der Totzeit zwischen dem Öffnen eines ersten Schaltelements einer Halbbrücke und dem Schließen eines zweiten Schaltelements der Halbbrücke, wobei die Halbbrücke ein Element eines Wechselrichters ist, welcher eine elektrische Maschine eines Kraftfahrzeugs versorgt. Hierzu wird die Totzeit eines Schaltzyklus relativ zur Totzeit eines vorangegangenen Schaltzyklus verringert. Die Temperatur von mindestens einem der Schaltelemente wird ermittelt. Die Verringerung der Totzeit und das Ermitteln der Temperatur werden für nachfolgende Schaltzyklen solange wiederholt, bis eine kritische Totzeit erreicht wird, bei welcher eine Abbruchbedingung erfüllt ist. Ob die Abbruchbedingung erfüllt ist, wird anhand der ermittelten Temperatur bestimmt. Die Totzeit wird unter Berücksichtigung der kritischen Totzeit eingestellt.

Gemäß einem zweiten Aspekt betrifft die Erfindung demnach eine Vorrichtung gemäß Anspruch 11 zum Einstellen einer Totzeit zwischen dem Öffnen eines ersten Schaltelements einer Halbbrücke und dem Schließen eines zweiten Schaltelements der Halbbrücke, wobei die Halbbrücke ein Element eines Wechselrichters ist, welcher eine elektrische Maschine eines Kraftfahrzeugs versorgt. Die Vorrichtung umfasst eine Steuereinrichtung und eine Temperaturermittlungseinrichtung. Die Steuereinrichtung ist dazu ausgebildet, die Halbbrücke derart anzusteuern, dass das zweite Schaltelement der Halbbrücke nach einer Totzeit nach dem Öffnen des ersten Schaltelements geschlossen wird. Die Steuereinrichtung ist dazu ausgebildet, die Totzeit eines Schaltzyklus relativ zur Totzeit eines vorangegangenen Schaltzyklus zu verringern, wobei die Temperaturermittlungseinrichtung nach dem Verringern der Totzeit die Temperatur von mindestens einem der Schaltelemente ermittelt. Das Verringern der Totzeit und das Ermitteln der Temperatur wird für nachfolgende Schaltzyklen solange wiederholt, bis eine kritische Totzeit erreicht ist, bei welcher eine Abbruchbedingung erfüllt ist. Die Abbruchbedingung hängt von der ermittelten Temperatur ab. Die Steuereinrichtung stellt die Totzeit unter Berücksichtigung der kritischen Totzeit, bevorzugt dynamisch, ein.

Gemäß einem dritten Aspekt betrifft die Erfindung einen Wechselrichter mit einer Vielzahl von Halbbrücken, welche jeweils zwei Schaltelemente aufweisen. Der Wechselrichter weist weiter eine Vorrichtung zum Anpassen einer Totzeit auf.

Bevorzugte Ausführungsformen sind Gegenstand der jeweiligen Unteransprüche.

### Vorteile der Erfindung

Die Erfindung erlaubt eine, bevorzugt dynamische, Anpassung der Totzeiten für den Betrieb von Schaltelementen einer Halbbrücke. Die Totzeit wird hierzu vorzugsweise stetig reduziert, das heißt die Totzeit wird im Vergleich zur Totzeit des vorangehenden Schaltzyklus verringert. Die Totzeit kann jedoch auch nach einer vorgegebenen Anzahl von Schaltzyklen reduziert werden und bleibt somit während dieser Schaltzyklen konstant.

Ein Schaltzyklus umfasst mehrere unterschiedliche Schaltzustände oder Schaltstellungen der Schaltelemente der Halbbrücke, welche typischerweise in einer festen Reihenfolge durchlaufen werden. Während eines jeweiligen Schaltzustandes bleiben die Schaltelemente der Halbbrücke jeweils geöffnet oder geschlossen. Der Übergang zu einem neuen Schaltzustand innerhalb eines Schaltzyklus erfolgt durch Öffnen oder Schließen eines der Schaltelemente. Jeder Schaltzyklus umfasst vorzugsweise genau eine Totzeit zwischen dem Öffnen eines ersten Schaltelements der Halbbrücke und dem Schließen eines zweiten Schaltelements der Halbbrücke. Eine weitere Totzeit liegt zwischen dem Öffnen des zweiten Schaltelements und dem Schließen des ersten Schaltelements. Weiter können bei mehreren Halbbrücken diesen ebenfalls entsprechende Totzeiten zugeordnet werden.

Beispielsweise wird während eines Schaltzyklus das erste Schaltelement geöffnet und nach Ablauf einer ersten Totzeit das zweite Schaltelement geschlossen. Anschließend wird das zweite Schaltelement geöffnet und das erste Schaltelement geschlossen. In einem darauffolgenden Schaltzyklus kann nun das erste Schaltelement wiederum geöffnet werden, bis nach Ablauf einer zweiten Totzeit das zweite Schaltelement wiederum geschlossen wird. Die Dauer der zweiten Totzeit kann im Vergleich zur Dauer der ersten Totzeit reduziert werden.

Anhand der ermittelten Temperatur kann erkannt werden, ob aufgrund der reduzierten Totzeit , thermisch wirksame Querströme, insbesondere ein Kurzschluss, zwischen den Schaltelementen auftreten. Sobald dieser Punkt erreicht ist, ist die kritische Totzeit erreicht und eine weitere Verringerung der Totzeit führt zu einer noch stärkeren Erwärmung der Schaltelemente, welche es zu vermeiden gilt. Anhand der genauen Kenntnis der kritischen Totzeit kann der tatsächlich anzuwendende Wert für die Totzeit derart eingestellt werden, dass dieser möglichst klein ist, um einen guten Wirkungsgrad des Wechselrichters, d. h. eine maximale Leistungsausbeute zu erreichen, ohne dass unerwünschte thermische Effekte auftreten.

Sich langsam entwickelnde Verschlechterungen der Schaltelemente haben einen Einfluss auf die thermischen Quereinflüssen und entsprechend auf die Änderung der Temperatur bei einer Änderung der Totzeit. Aufgrund der dynamischen Anpassung der Totzeit können derartige Alterungseffekte der Schaltelemente kompensiert werden.

Die Schaltelemente können vorzugsweise Leistungs-Halbleiter-Schaltelemente aufweisen, insbesondere Metalloxid-Feldeffekttransistoren (MOSFETs) oder bipolare Transistoren, insbesondere mit einem isolierten Gate-Anschluss (IGBTs).

Gemäß einer bevorzugten Weiterbildung des Verfahrens umfasst das Ermitteln der Temperatur das Messen von elektrischen Strömen und/oder Spannungen an Ausgängen des jeweiligen Schaltelements. Handelt es sich bei dem Schaltelement um einen MOSFET, können beispielsweise der Drainstrom, die Drain-Source-Spannung und die Gate-Source-Spannung unter Verwendung von schnellen Analog-Digital-Wandlern während einer PWM-Schaltperiode gemessen werden und zur Ermittlung der Temperatur herangezogen werden. Handelt es sich bei dem Schaltelement um ein IGBT, werden die analogen Ströme und Spannungen an Gate, Kollektor und Emitter gemessen.

Gemäß einer bevorzugten Ausführungsform des Verfahrens wird anhand der gemessenen elektrischen Ströme und Spannungen und anhand einer vorgegebenen Kennlinie des jeweiligen Schaltelements die Temperatur des Schaltelements bestimmt. Die Spannungen und Ströme der Schaltelemente sind temperaturabhängig. Die genauen Zusammenhänge von den Werten der Ströme bzw. Spannungen und den entsprechenden Temperaturen können anhand von Datenblattwerten in Look-up-Tabellen (LUT) abgespeichert werden.

Über Look-up-Tabellen kann somit anhand der gemessenen Ströme und Spannungen sehr schnell die Temperatur des entsprechenden Schaltelements ermittelt werden. Alternativ kann die Temperaturabhängigkeit der Ströme und Spannungen anhand von physikalischen Modellen berechnet werden. Mittels geeigneter uC-Schaltungen kann anhand der entsprechenden mathematischen Funktionen und unter Berücksichtigung der Kennlinien des Schaltelements die momentane Temperatur der Schaltelemente ermittelt werden.

Gemäß einer bevorzugten Weiterbildung des Verfahrens erfolgt das Einstellen der Totzeit durch Addieren der kritischen Totzeit mit einem vorgegebenen Sicherheitszeitpuffer. Der Sicherheitszeitpuffer wird vorzugsweise derart gewählt, dass die eingestellte Totzeit hinreichend weit von der kritischen Totzeit entfernt ist, sodass die thermisch wirksamen Querströme zwischen den Schaltelementen hinreichend gut eliminiert werden. Gemäß weiteren Ausführungsformen kann die kritische Totzeit mit einem vorgegebenen Faktor multipliziert werden, welcher größer als 1 ist, um die angepasste Totzeit zu erhalten. Gemäß einer bevorzugten Weiterbildung des Verfahrens wird zum Ermitteln der kritischen Totzeit die ermittelte Temperatur mit einem vorgegebenen Temperatur-Schwellenwert verglichen. Überschreitet die ermittelte Temperatur den vorgegebenen Temperatur-Schwellenwert, ist die Abbruchbedingung erfüllt.

Gemäß einer bevorzugten Ausführungsform hängt die Abbruchbedingung von einer Änderung der ermittelten Temperatur nach mindestens einem Schaltzyklus ab. Beispielsweise kann die Änderung der Temperaturdifferenz zwischen zwei aufeinanderfolgenden Schaltzyklen betrachtet werden. Überschreitet diese einen vorgegebenen Schwellenwert, ist die Abbruchbedingung erfüllt.

Gemäß einer bevorzugten Weiterbildung des Verfahrens wird zum Ermitteln der kritischen Totzeit ein Gradient der ermittelten Temperatur mit einem vorgegebenen Gradient-Schwellenwert verglichen. Der Gradient der ermittelten Temperatur kann beispielsweise eine Änderung der ermittelten Temperatur als Funktion der Zeit bei einem Ausschaltprozess, oder auch die Änderung der ermittelten Temperatur als Funktion der Totzeit sein. Überschreitet der Gradient den vorgegebenen Gradient-Schwellenwert, ist die Abbruchbedingung erfüllt.

Gemäß bevorzugten Ausführungsformen kann ermittelt werden, ob nach der Änderung der Totzeit innerhalb eines vorgegebenen Messzeitraums eine signifikante Erhöhung der Temperatur stattfindet. Die Temperaturerhöhung kann hierzu mit einem vorgegebenen Schwellenwert verglichen werden. Der Messzeitraum kann aufgrund der wirkenden trägen thermischen Effekte entsprechend der Maßnahmen der Halbleiterentwärmung einige Millisekunden bis zu mehreren hundert Millisekunden betragen.

Gemäß einer bevorzugten Weiterbildung des Verfahrens wird das Einstellen der Totzeit sukzessive für sämtliche Halbbrücken eines Wechselrichters durchgeführt. Für jede der Halbbrücken wird eine Totzeit zwischen dem Öffnen des ersten Schaltelements der jeweiligen Halbbrücke und dem Schließen des zweiten Schaltelements der jeweiligen Halbbrücke eingestellt und weiter eine Totzeit zwischen dem Öffnen des zweiten Schaltelements der jeweiligen Halbbrücke und dem Schließen des ersten Schaltelements der jeweiligen Halbbrücke eingestellt. Für eine beispielhafte B6-Brücke, welche aus drei Halbbrücken zusammengesetzt ist, werden entsprechend sechs verschiedene Totzeiten angepasst und eingestellt.

Gemäß des erfindungsgemäßen Verfahrens handelt es sich bei der Halbbrücke um ein Element für eine elektrische Versorgung einer Antriebsmaschine. Erfindungsgemäß ist die Halbbrücke Teil eines Wechselrichters für eine derartige Antriebsmaschine. Das Verfahren wird dann durchgeführt, wenn die Antriebsmaschine bei Nulllast betrieben wird, also kein Drehmoment abgegeben wird. Bei der Antriebsmaschine handelt es sich um einen Antrieb für ein Kraftfahrzeug. Durch Betreiben bei Nulllast ist das kontinuierliche Schalten der Halbbrücken gewährleistet.

Gemäß einer Weiterbildung des Verfahrens ist die Halbbrücke ein Element eines Wechselrichters, wobei das Einstellen der Totzeit während eines Einschaltvorgangs des Wechselrichters und/oder während eines Ausschaltvorgangs des Wechselrichters erfolgt. Dadurch wird eine Anpassung der Totzeiten über die Betriebs- oder Lebensdauer des Wechselrichters erreicht, sodass insbesondere Alterungseffekte korrigiert werden können. Bevorzugt wird die Temperatur jeweils während der Totzeit ermittelt. Hierbei kann ein kontinuierlicher Temperaturverlauf ermittelt werden, etwa durch Generieren mehrerer Temperaturmesswerte und Interpolation der Temperaturmesswerte, oder es kann auch nur ein einzelner Messwert während der Totzeit ermittelt werden. Es ist jedoch auch möglich, die Temperatur jeweils zu einem Zeitpunkt außerhalb der Totzeit zu messen, etwa kurz nach dem Ende der Totzeit.

Gemäß einer bevorzugten Weiterbildung der Vorrichtung umfasst die Temperaturermittlungseinrichtung einen Sensor zum Messen von Strömen und Spannungen an Ausgängen der jeweiligen Schaltelemente.

Gemäß einer bevorzugten Weiterbildung der Vorrichtung ist die Steuereinrichtung dazu ausgebildet, anhand der gemessenen Ströme und Spannungen und unter Berücksichtigung einer vorgegebenen Kennlinie des jeweiligen Schaltelements die Temperatur des Schaltelements zu bestimmen.

### Kurze Beschreibung der Zeichnungen

Es zeigen:
- Figur 1: ein schematisches Blockschaltbild einer Vorrichtung zum Einstellen der Totzeit gemäß einer Ausführungsform der Erfindung;
- Figur 2: ein schematisches Blockschaltbild eines Wechselrichters gemäß einer Ausführungsform der Erfindung;
- Figur 3: ein schematisches Schaltbild von Halbbrücken des Wechselrichters; und
- Figur 4: ein schematisches Flussdiagramm eines Verfahrens zum Einstellen einer Totzeit gemäß einer Ausführungsform der Erfindung.

In allen Figuren sind gleiche bzw. funktionsgleiche Elemente und Vorrichtungen mit denselben Bezugszeichen versehen. Die Nummerierung von Verfahrensschritten dient der Übersichtlichkeit und soll im Allgemeinen keine bestimmte zeitliche Reihenfolge implizieren. Insbesondere können auch mehrere Verfahrensschritte gleichzeitig durchgeführt werden.

### Beschreibung der Ausführungsbeispiele

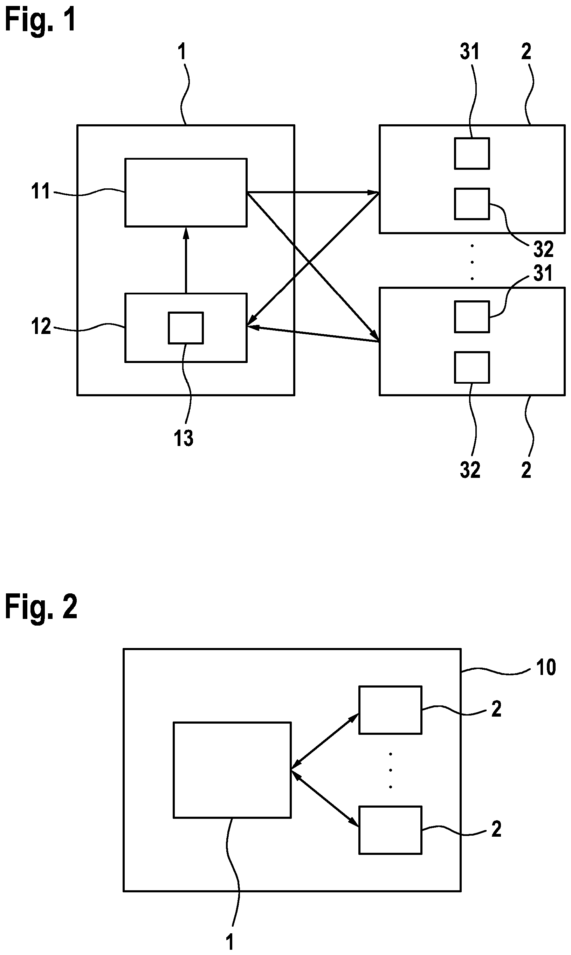

Figur 1 zeigt ein schematisches Blockschaltbild einer Vorrichtung 1 zum Einstellen einer Totzeit tTD zwischen dem Öffnen eines jeweiligen ersten Schaltelements 31 und dem Schließen eines jeweiligen zweiten Schaltelements 32 von Halbbrücken 2. Die Halbbrücken 2 sind Teil eines Wechselrichters, welcher wiederum ein Element eines elektrischen Antriebssystems ist. Der Wechselrichter ist hierzu mit einer Gleichspannungsquelle verbunden und wandelt die eingangsseitig bereitgestellte Gleichspannung in eine Wechselspannung um, welche einer mehrphasigen elektrischen Maschine ausgangsseitig bereitgestellt wird. Für jede Phase der elektrischen Maschine umfasst der Wechselrichter eine entsprechende Halbbrücke 2. Beispielsweise kann eine dreiphasige elektrische Maschine mittels einer B6-Brücke aus drei Halbbrücken 2 angesteuert werden.

Die Schaltelemente 31, 32 sind in Serie zwischen einem positiven Eingangsanschluss des Wechselrichters und einem negativen Eingangsanschluss des Wechselrichters angeordnet. Ein Verbindungspunkt zwischen dem ersten und zweiten Schaltelement der Halbbrücke 2 ist jeweils mit einem Phasenanschluss der elektrischen Maschine gekoppelt. Die Schaltelemente 31, 32 können beispielsweise MOSFETs oder IGBTs aufweisen. Die Erfindung ist jedoch nicht auf derartige Elemente beschränkt. Vielmehr kann es sich bei den Schaltelementen um beliebige Halbleiter-Schaltelemente handeln.

Die Vorrichtung 1 umfasst eine Steuereinrichtung 11, welche dazu ausgebildet ist, die Halbbrücken 2 des Wechselrichters anzusteuern. Die Vorrichtung 1 kann hierzu selbst ein Element des Wechselrichters sein oder auch eine von dem Wechselrichter getrennte Einheit. Die Steuereinrichtung 11 überträgt ein Ansteuersignal an die jeweilige Halbbrücke 2, sodass das zweite Schaltelement 32 der Halbbrücke 2 nach einer Totzeit tTD nach dem Öffnen des ersten Schaltelements 31 geschlossen wird. Die feinstufige Anpassung der Totzeit tTD durch Anpassen der Ein- und Ausschaltzeiten der Schaltelemente 31, 32 kann durch Software-Routinen eines Mikrocontrollers durchgeführt werden. Die Totzeit tTD kann im Nanosekundenbereich variiert werden. Die Schaltflanken können an den PWM-Ausgängen mittels Software verschoben werden. Die Ein- und Ausschaltvorgänge der Schaltelemente 31, 32 werden durch zahlreiche Faktoren beeinflusst. Hierzu gehören beispielsweise die Ein- und Ausschaltverzögerungszeiten der Schaltelemente und weitere für die Ansteuerung und Verriegelungs-, Mess-, Schutz- und Überwachungsfunktionen notwendige Mindest-Ein- und -Auszeiten bzw. Totzeiten. Zusätzlich treten Verzögerungszeiten im Treiber auf, deren Temperaturabhängigkeit und Alterungsverhalten nicht bekannt sind.

Bei einer zu kurz bemessenen Totzeit tTD kann es zu unerwünschten thermischen Quereinflüssen kommen. Die Steuereinrichtung 11 ist daher dazu ausgelegt, die Totzeit tTD zuerst auf einen Anfangswert festzulegen, welcher groß genug gewählt ist, sodass keine thermischen Störeinflüsse zu erwarten sind. Ein derartiger Wert kann beispielsweise empirisch ermittelt werden. Die Steuereinrichtung 11 ist dazu ausgebildet, die Totzeit tTD ausgehend von dem Anfangswert sukzessive zu verringern.

Die Vorrichtung 1 umfasst weiter eine Temperaturermittlungseinrichtung 12, welche eine Temperatur T der beiden Schaltelemente 31, 32 ermittelt. Die Temperaturermittlungseinrichtung 12 ist aus Genauigkeitsgründen vorzugsweise zur Erfassung der Temperatur des ersten Schaltelements 31 identisch ausgebildet wie zur Erfassung der Temperatur des zweiten Schaltelements 32. Zum Einstellen der Totzeit tTD zwischen dem Öffnen des ersten Schaltelements 31 und dem Schließen des zweiten Schaltelements 32 kann die Temperaturermittlungseinrichtung 12 beispielsweise die Temperatur des ersten Schaltelements 31 ermitteln. Gemäß weiteren Ausführungsformen kann die Temperaturermittlungseinrichtung 12 jedoch auch eine erste Temperatur T1 des ersten Schaltelements 31 und eine zweite Temperatur T2 des zweiten Schaltelements 32 ermitteln.

Die Temperaturermittlungseinrichtung 12 umfasst vorzugsweise Stromsensoren und Spannungssensoren, welche dazu ausgebildet sind, an den Ausgängen der Schaltelemente 31, 32 anliegende Spannungen bzw. durch die Ausgänge fließende Ströme zu messen. Die Sensorelemente können insbesondere einen Drainstrom, eine Drain-Source-Spannung und eine Gate-Source-Spannung eines MOSFETs oder entsprechende Ströme und Spannungen an Gate, Kollektor und Emitter eines IGBTs messen. Die Vorrichtung 1 kann weiter eine Speichereinrichtung aufweisen, in welcher Kennlinien der jeweiligen Schaltelemente abgelegt sind, welche die Temperaturabhängigkeit der Schaltelemente angeben. Unter Verwendung dieser Kennlinien und der gemessenen Ströme und Spannungen ermittelt die Temperaturermittlungseinrichtung 12 die Junction-Temperatur des jeweiligen Schaltelements 31, 32.

Die Steuereinrichtung 11 überwacht während des Anpassens der Totzeit tTD die ermittelte Temperatur. Hierzu kann während jeder Totzeit tTD ein entsprechender Temperaturwert oder ein Temperaturverlauf ermittelt werden. Falls eine absolute Temperatur oder ein Temperaturanstieg bzw. eine Änderung der ermittelten Temperatur für zwei aufeinander folgende Totzeiten einen vorgegebenen Schwellenwert überschreitet, erkennt die Steuereinrichtung 11, dass die Temperatur zu stark ansteigt, sodass ein Abbruchkriterium erfüllt ist und eine kritische Totzeit tK erreicht ist. Insbesondere kann die Steuereinrichtung 11 einen Gradienten der ermittelten Temperatur mit dem vorgegebenen Schwellenwert vergleichen. Der Schwellenwert kann in Abhängigkeit von den thermischen Eigenschaften der entsprechenden Schaltelemente 31, 32 festgelegt werden. Insbesondere können die Temperaturempfindlichkeiten der Schaltelemente 31, 32 zur Festlegung des Schwellenwertes berücksichtigt werden.

Die Steuereinrichtung 11 ermittelt nun eine neue vorzugebende oder einzustellendeTotzeit tTD durch Addieren der kritischen Totzeit tK mit einem vorgegebenen Sicherheitspuffer. Alternativ kann die kritische Totzeit tK mit einem vorgegebenen Faktor größer als 1 multipliziert werden.

Die Steuereinrichtung 11 ist dazu ausgebildet, die Halbbrücke anschließend derart anzusteuern, dass die Totzeit tTD zwischen dem Öffnen des ersten Schaltelements 31 und dem Schließen des zweiten Schaltelements 32 auf den ermittelten Wert eingestellt wird.

Die beschriebene Anpassung wird anschließend vorzugsweise für die Totzeit tTD zwischen dem Öffnen des zweiten Schaltelements 32 und dem Schließen des ersten Schaltelements 31 wiederholt. Anschließend werden die jeweiligen Totzeiten tTD für sämtliche weitere Halbbrücken 2 dynamisch ermittelt.

In Figur 2 ist ein schematisches Blockschaltbild eines Wechselrichters 10 gemäß einer Ausführungsform der Erfindung illustriert. Der Wechselrichter 10 umfasst eine Vielzahl von Halbbrücken 2, beispielsweise drei Halbbrücken 2 in Form einer B6-Brücke. Jede der Halbbrücken 2 weist ein erstes Schaltelement 31 und ein zweites Schaltelement 32 auf. Weiter umfasst der Wechselrichter 10 eine oben beschriebene Vorrichtung 1 zum Einstellen von Totzeiten tTD zwischen dem Öffnen eines Schaltelements 31, 32 der Halbbrücke 2 und dem Schließen des jeweiligen anderen Schaltelements 31, 32 der Halbbrücke 2.

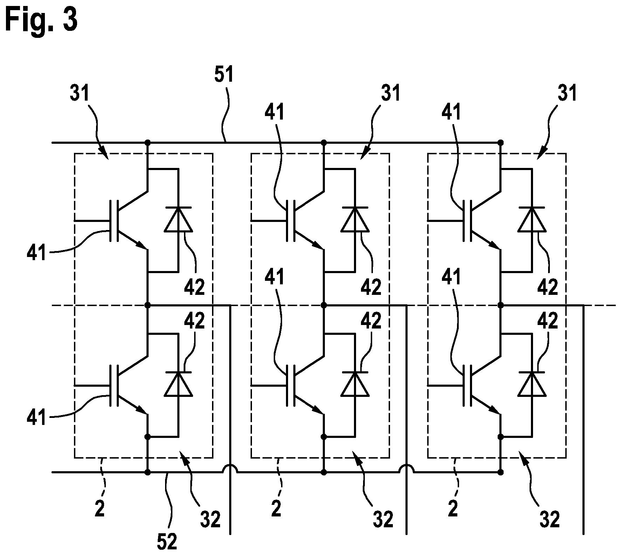

In Figur 3 ist eine beispielhafte B6-Brückenschaltung illustriert, wie sie in einem erfindungsgemäßen Wechselrichter 10 Anwendung finden kann. Der Wechselrichter 10 umfasst drei Halbbrücken 2, welche zwischen einer positiven Highside-Seite 51 (T+) und einer negativen Lowside-Seite 52 (T-) geschaltet sind. Jede der Halbbrücken 2 umfasst ein erstes (High-Side-)Schaltelement 31 und ein zweites (Low-Side-)Schaltelement 32 mit jeweiligen Halbleiterschaltern 41 und parallelgeschalteten Freilaufdioden 42. Die Halbleiterschalter 41 sind beispielsweise MOSFETS oder IGBTs. Die Verbindungsknoten zwischen den ersten Schaltelementen 31 und den zweiten Schaltelementen 32 sind jeweils mit einem Phasenanschluss einer elektrischen Maschine verknüpft. Die Erfindung ist jedoch nicht auf die gezeigte Ausführungsform beschränkt. So kann der Wechselrichter 10 eine beliebige Anzahl von Halbbrücken 2 aufweisen.

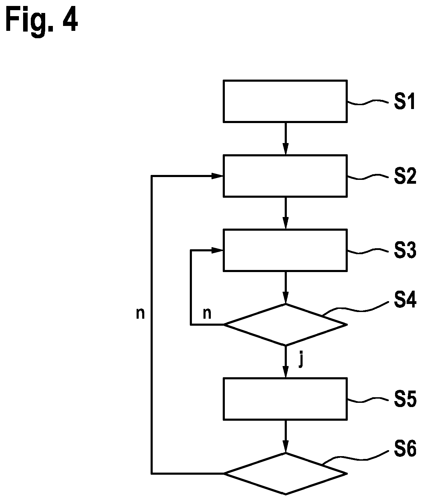

In Figur 4 ist ein Flussdiagramm eines Verfahrens zum Einstellen einer Totzeit tTD zwischen dem Öffnen eines ersten Schaltelements 31 einer Halbbrücke 2 und dem Schließen eines zweiten Schaltelements 32 der Halbbrücke 2 illustriert.

Die Halbbrücke 2 ist ein Element eines Wechselrichters 10, welcher die von einer Gleichspannungsquelle bereitgestellte elektrische Energie in eine Wechselspannung umwandelt und einer elektrischen Maschine eines Kraftfahrzeugs bereitstellt. Hierzu wird in einem ersten Verfahrensschritt S1 sichergestellt, dass das Fahrzeug sicher abgestellt ist, d. h. gegen Wegrollen gesichert ist, etwa durch Aktivieren einer Handbremse des Fahrzeugs. Der Wechselrichter 10 wird weiter in einen Betriebsmodus versetzt, bei welchem keine Drehmomente an den Antriebsrädern des Fahrzeugs erzeugt werden. Bei dieser Null-Momenten-Regelung muss gleichzeitig das kontinuierliche Schalten der Schaltelemente 31, 32 gewährleistet werden. Das Verfahren wird somit bevorzugt bei Nulllast durchgeführt.

In einem Verfahrensschritt S2 wird die Totzeit tTD zwischen dem Öffnen des ersten Schaltelements 31 und dem Schließen des zweiten Schaltelements 32 auf einen Anfangswert eingestellt, welcher für sämtliche Halbleiterelemente unkritisch ist.

In einem Verfahrensschritt S3 wird die Totzeit tTD sukzessive verringert, während parallel die Temperatur von mindestens einem der Schaltelemente 31, 32 ermittelt wird.

In einem Verfahrensschritt S4 wird erkannt, ob die Änderung der Totzeit tTD eine signifikante Änderung der Temperatur nach sich zieht. Dazu kann beispielsweise die Temperatur oder ein Gradient der Temperatur mit einem vorgegebenen Schwellenwert verglichen werden. Überschreitet die Temperatur oder der Gradient der Temperatur, d. h. beispielsweise die Ableitung der Temperatur nach der Totzeit tTD, den Schwellenwert nicht, so wird die Totzeit tTD weiter verringert, S3. Andernfalls wird in einem Verfahrensschritt S5 erkannt, dass eine kritische Totzeit tK erreicht wurde. Ein Abbruchkriterium ist erfüllt und die schrittweise Verringerung der Totzeit tTD wird beendet. Die Totzeit tTD wird unter Berücksichtigung der kritischen Totzeit tK eingestellt. Hierzu wird vorzugsweise ein Sicherheitszeitpuffer zur kritischen Totzeit tK addiert, um die angepasste Totzeit tTD zu erhalten.

In einem Verfahrensschritt S6 wird überprüft, ob weitere Totzeiten tTD angepasst werden müssen. Für jede Halbbrücke 2 müssen zwei Totzeiten tTD angepasst werden, einerseits die Totzeit tTD zwischen dem Öffnen des ersten Schaltelements 31 der Halbbrücke 2 und dem Schließen des zweiten Schaltelements 32 der Halbbrücke 2 und andererseits die Totzeit tTD zwischen dem Öffnen des zweiten Schaltelements 32 der Halbbrücke 2 und dem Schließen des ersten Schaltelements 31 der Halbbrücke 2. Die Verfahrensschritte S2 bis S5 werden für sämtliche Halbbrücken 2 und für jeweils beide Schaltelemente 31, 32 durchgeführt. Bei der in Figur 3 illustrierten B6-Halbbrücke werden somit insgesamt sechs Totzeiten tTD eingestellt. Falls sämtliche Totzeiten tTD bereits angepasst wurden, wird das Verfahren beendet.

Die ermittelten angepassten Totzeiten tTD können in einem nicht flüchtigen Speicher abgelegt werden und können bei einer wiederholten Durchführung des Verfahrens zum Einstellen des Anfangswerts der Totzeit tTD herangezogen werden. Vorzugsweise wird das Verfahren nach vorgegebenen Zeiträumen erneut durchgeführt, um Alterungseffekte und sich ändernde Umgebungsbedingungen zu kompensieren. Das Verfahren kann beispielsweise bei jedem Einschaltvorgang und/oder Ausschaltvorgang oder in Passivphasen des Wechselrichters durchgeführt werden.

## Patentansprüche

1. Verfahren zum Einstellen einer Totzeit zwischen dem Öffnen eines ersten Schaltelements (31) einer Halbbrücke (2) und dem Schließen eines zweiten Schaltelements (32) der Halbbrücke (2),
wobei die Halbbrücke (2) ein Element eines Wechselrichters (10) ist, welcher die von einer Gleichspannungsquelle bereitgestellte elektrische Energie in eine Wechselspannung umwandelt und einer elektrischen Maschine eines Kraftfahrzeugs bereitstellt,
mit den Schritten:
Versetzen des Wechselrichters (10) in einen Betriebsmodus, bei dem kein Drehmoment an den Antriebsrädern des Kraftfahrzeugs erzeugt wird und das kontinuierliche Schalten der Schaltelemente (31, 32) ermöglicht wird,
Verringern der Totzeit eines Schaltzyklus relativ zur Totzeit eines vorangegangenen Schaltzyklus, und
Ermitteln einer Temperatur von mindestens einem der Schaltelemente (31, 32);
wobei die Schritte des Verringerns der Totzeit und des Ermittelns der Temperatur für nachfolgende Schaltzyklen solange wiederholt werden, bis eine kritische Totzeit erreicht ist, bei welcher eine Abbruchbedingung erfüllt ist, welche von der ermittelten Temperatur abhängt; und
wobei die Totzeit unter Berücksichtigung der kritischen Totzeit eingestellt wird.

2. Verfahren nach Anspruch 1, wobei das Ermitteln der Temperatur eine Messung von Strömen und/oder Spannungen an Ausgängen des jeweiligen Schaltelements (31, 32) umfasst.

3. Verfahren nach Anspruch 2, wobei anhand der gemessenen Ströme und Spannungen und einer vorgegebenen Kennlinie des jeweiligen Schaltelements (31, 32) die Temperatur des Schaltelements (31, 32) bestimmt wird.

4. Verfahren nach einem der vorangehenden Ansprüche, wobei das Einstellen der Totzeit durch Addieren der kritischen Totzeit mit einem vorgegebenen Sicherheitszeitpuffer erfolgt.

5. Verfahren nach einem der vorangehenden Ansprüche, wobei die Abbruchbedingung umfasst, dass die ermittelte Temperatur einen vorgegebenen Temperatur-Schwellenwert überschreitet.

6. Verfahren nach einem der vorangehenden Ansprüche, wobei die Abbruchbedingung von einer Änderung der ermittelten Temperatur nach mindestens einem Schaltzyklus abhängt.

7. Verfahren nach einem der vorangehenden Ansprüche, wobei die Abbruchbedingung umfasst, dass ein Gradient der ermittelten Temperatur einen vorgegebenen Schwellenwert überschreitet.

8. Verfahren nach einem der vorangehenden Ansprüche, wobei das Einstellen der Totzeit sukzessive für sämtliche Halbbrücken (2) eines Wechselrichters (10) durchgeführt wird, wobei jeweils eine erste Totzeit zwischen dem Öffnen des ersten Schaltelements (31) der jeweiligen Halbbrücke (2) und dem Schließen des zweiten Schaltelements (32) der jeweiligen Halbbrücke (2) und eine zweite Totzeit zwischen dem Öffnen des zweiten Schaltelements (32) der jeweiligen Halbbrücke (2) und dem Schließen des ersten Schaltelements (31) der jeweiligen Halbbrücke (2) eingestellt wird.

9. Verfahren nach einem der vorangehenden Ansprüche, wobei die Halbbrücke (2) ein Element eines Wechselrichters (10) ist, wobei das Einstellen der Totzeit während eines Einschaltvorgangs des Wechselrichters (10) und/oder während eines Ausschaltvorgangs des Wechselrichters (10) erfolgt.

10. Verfahren nach einem der vorangehenden Ansprüche, wobei das Ermitteln der Temperatur des mindestens einen der Schaltelemente (31, 32) während der Totzeit erfolgt.

11. Vorrichtung (1) zum Einstellen einer Totzeit zwischen dem Öffnen eines ersten Schaltelements (31) einer Halbbrücke (2) und dem Schließen eines zweiten Schaltelements (32) der Halbbrücke (2),
wobei die Halbbrücke (2) ein Element eines Wechselrichters (10) ist, welcher die von einer Gleichspannungsquelle bereitgestellte elektrische Energie in eine Wechselspannung umwandelt und einer elektrischen Maschine eines Kraftfahrzeugs bereitstellt,
mit
einer Steuereinrichtung (11), welche dazu ausgebildet ist, die Halbbrücke (2) derart anzusteuern, dass das zweite Schaltelement (32) der Halbbrücke (2) nach einer Totzeit nach dem Öffnen des ersten Schaltelementes (31) geschlossen wird; und
einer Temperaturermittlungseinrichtung (12), welche dazu ausgebildet ist, eine Temperatur von mindestens einem der Schaltelemente (31, 32) zu ermitteln; wobei die Steuereinrichtung (11) dazu ausgebildet ist,
den Wechselrichter (10) in einen Betriebsmodus zu versetzen, bei dem kein Drehmoment an den Antriebsrädern erzeugt wird und das kontinuierliche Schalten der Schaltelemente (31, 32) ermöglicht wird,
die Totzeit eines Schaltzyklus relativ zur Totzeit eines vorangegangenen Schaltzyklus zu verringern, wobei die Temperaturermittlungseinrichtung (12) dazu ausgebildet ist, nach dem Verringern der Totzeit die Temperatur von mindestens einem der Schaltelemente (31, 32) zu ermitteln,
wobei die Steuereinrichtung (11) und die Temperaturermittlungseinrichtung (12) dazu ausgebildet sind, das Verringern der Totzeit und das Ermitteln der Temperatur für nachfolgende Schaltzyklen solange zu wiederholen, bis eine kritische Totzeit erreicht ist, bei welcher eine Abbruchbedingung erfüllt ist, welche von der ermittelten Temperatur abhängt;
und wobei die Steuereinrichtung (11) dazu ausgebildet ist, die Totzeit unter Berücksichtigung der kritischen Totzeit einzustellen.

12. Vorrichtung (1) nach Anspruch 11, wobei die Temperaturermittlungseinrichtung (12) einen Sensor (13) zum Messen von elektrischen Strömen und/oder Spannungen an Ausgängen des jeweiligen Schaltelements umfasst.

13. Vorrichtung (1) nach einem der Ansprüche 11 oder 12, wobei die Steuereinrichtung (11) dazu ausgebildet ist, anhand der gemessenen elektrischen Ströme und Spannungen und einer vorgegebenen Kennlinie des jeweiligen Schaltelements (31, 32) die Temperatur (T) des Schaltelements (31, 32) zu bestimmen.

14. Wechselrichter (10), mit einer Vielzahl von Halbbrücken (2), welche jeweils zwei Schaltelemente (31, 32) aufweisen, und einer Vorrichtung (1) gemäß einem der Ansprüche 11 bis 13 zum Einstellen von Totzeiten zwischen dem Öffnen und Schließen jeweiliger Schaltelemente (31, 32) der Halbbrücken (2).

## Claims

1. Method for setting a dead time between the opening of a first switching element (31) of a half bridge (2) and the closing of a second switching element (32) of the half bridge (2),
wherein the half bridge (2) is an element of an inverter (10) which converts the electrical energy provided by a DC voltage source into an AC voltage and provides it to an electric machine of a motor vehicle,
with the steps of:
placing the inverter (10) in an operating mode in which no torque is generated at the drive wheels of the motor vehicle and the continuous switching of the switching elements (31, 32) is made possible,
reducing the dead time of a switching cycle relative to the dead time of a preceding switching cycle, and
ascertaining a temperature of at least one of the switching elements (31, 32); wherein the steps of reducing the dead time and ascertaining the temperature are repeated for subsequent switching cycles until a critical dead time at which a stop condition is satisfied that depends on the temperature ascertained is reached; and
wherein the dead time is set in the light of the critical dead time.

2. Method according to Claim 1, wherein the ascertainment of the temperature comprises a measurement of currents and/or voltages at outputs of the respective switching element (31, 32).

3. Method according to Claim 2, wherein the temperature of the switching element (31, 32) is determined on the basis of the measured currents and voltages and of a predefined characteristic curve of the respective switching element (31, 32).

4. Method according to one of the preceding claims, wherein the setting of the dead time occurs by adding a predefined safety buffer time to the critical dead time.

5. Method according to one of the preceding claims, wherein the stop condition involves the ascertained temperature exceeding a predefined temperature threshold value.

6. Method according to one of the preceding claims, wherein the stop condition depends on a change in the ascertained temperature after at least one switching cycle.

7. Method according to one of the preceding claims, wherein the stop condition involves a gradient of the ascertained temperature exceeding a predefined threshold value.

8. Method according to one of the preceding claims, wherein the setting of the dead time is performed successively for all of the half bridges (2) of an inverter (10), wherein in each case a first dead time between the opening of the first switching element (31) of the respective half bridge (2) and the closing of the second switching element (32) of the respective half bridge (2) is set and a second dead time between the opening of the second switching element (32) of the respective half bridge (2) and the closing of the first switching element (31) of the respective half bridge (2) is set.

9. Method according to one of the preceding claims, wherein the half bridge (2) is an element of an inverter (10), wherein the setting of the dead time takes place during a switch-on procedure of the inverter (10) and/or during a switch-off procedure of the inverter (10).

10. Method according to one of the preceding claims, wherein the ascertainment of the temperature of the at least one of the switching elements (31, 32) takes place during the dead time.

11. Device (1) for setting a dead time between the opening of a first switching element (31) of a half bridge (2) and the closing of a second switching element (32) of the half bridge (2),
wherein the half bridge (2) is an element of an inverter (10) which converts the electrical energy provided by a DC voltage source into an AC voltage and provides it to an electric machine of a motor vehicle,
with
a control device (11) that is designed to drive the half bridge (2) in such a way that the second switching element (32) of the half bridge (2) is closed after a dead time following the opening of the first switching element (31); and
a temperature ascertainment device (12) that is designed to ascertain a temperature of at least one of the switching elements (31, 32);
wherein the control device (11) is designed to
place the inverter (10) in an operating mode in which no torque is generated at the drive wheels and the continuous switching of the switching elements (31, 32) is made possible,
reduce the dead time of a switching cycle relative to the dead time of a preceding switching cycle, wherein the temperature ascertainment device (12) is designed, following the reduction of the dead time, to ascertain the temperature of at least one of the switching elements (31, 32),
wherein the control device (11) and the temperature ascertainment device (12) are designed to repeat the reduction of the dead time and the ascertainment of the temperature for subsequent switching cycles until a critical dead time at which a stop condition is satisfied that depends on the ascertained temperature is reached;
and wherein the control device (11) is designed to set the dead time in the light of the critical dead time.

12. Device (1) according to Claim 11, wherein the temperature ascertainment device (12) comprises a sensor (13) for measuring electric currents and/or voltages at outputs of the respective switching element.

13. Device (1) according to either of Claims 11 and 12, wherein the control device (11) is designed to determine the temperature (T) of the switching element (31, 32) on the basis of the measured electric currents and voltages and a predefined characteristic curve of the respective switching element (31, 32).

14. Inverter (10) with a plurality of half bridges (2), each of which comprises two switching elements (31, 32), and a device (1) according to one of Claims 11 to 13 for setting dead times between the opening and the closing of respective switching elements (31, 32) of the half bridges (2).

## Revendications

1. Procédé de réglage d'un temps mort entre l'ouverture d'un premier élément de commutation (31) d'un demi-pont (2) et la fermeture d'un second élément de commutation (32) du demi-pont (2),
le demi-pont (2) étant un élément d'un onduleur (10) qui convertit l'énergie électrique fournie par une source de tension continue en une tension alternative et la fournit à une machine électrique d'un véhicule à moteur,
avec les étapes :
placement de l'onduleur (10) dans un mode de fonctionnement dans lequel aucun couple de rotation n'est généré sur les roues motrices du véhicule à moteur et la commutation continue des éléments de commutation (31, 32) est rendue possible,
réduction du temps mort d'un cycle de commutation par rapport au temps mort d'un cycle de commutation précédent, et
détermination d'une température d'au moins un des éléments de commutation (31, 32) ;
les étapes de réduction du temps mort et de détermination de la température pour des cycles de commutation suivants étant répétées jusqu'à atteindre un temps mort critique, auquel une condition d'arrêt est remplie, qui dépend de la température déterminée ; et
le temps mort étant réglé en tenant compte du temps mort critique.

2. Procédé selon la revendication 1, la détermination de la température comprenant une mesure de courants et/ou de tensions sur des sorties de l'élément de commutation (31, 32) respectif.

3. Procédé selon la revendication 2, la température de l'élément de commutation (31, 32) étant définie à l'aide des courants et tensions mesurés et d'une courbe caractéristique spécifiée de l'élément de commutation (31, 32) respectif.

4. Procédé selon l'une des revendications précédentes, le réglage du temps mort étant effectué en ajoutant le temps mort critique à un tampon de temps de sécurité spécifié.

5. Procédé selon l'une des revendications précédentes, la condition d'arrêt comprenant le fait que la température déterminée dépasse une valeur de seuil de température spécifiée.

6. Procédé selon l'une des revendications précédentes, la condition d'arrêt dépendant d'un changement de la température déterminée après au moins un cycle de commutation.

7. Procédé selon l'une des revendications précédentes, la condition d'arrêt comprenant le fait qu'un gradient de la température déterminée dépasse une valeur de seuil spécifiée.

8. Procédé selon l'une des revendications précédentes, le réglage du temps mort étant mis en œuvre successivement pour tous les demi-ponts (2) d'un onduleur (10), un premier temps mort entre l'ouverture du premier élément de commutation (31) du demi-pont (2) respectif et la fermeture du second élément de commutation (32) du demi-pont (2) respectif et un deuxième temps mort entre l'ouverture du second élément de commutation (32) du demi-pont (2) respectif et la fermeture du premier élément de commutation (31) du demi-pont (2) respectif étant chacun réglés.

9. Procédé selon l'une des revendications précédentes, le demi-pont (2) étant un élément d'un onduleur (10), le réglage du temps mort pendant une opération de mise sous tension de l'onduleur (10) et/ou pendant une opération de mise hors tension de l'onduleur (10) étant effectué.

10. Procédé selon l'une des revendications précédentes, la détermination de la température de l'au moins un des éléments de commutation (31, 32) pendant le temps mort étant effectuée.

11. Dispositif (1) de réglage d'un temps mort entre l'ouverture d'un premier élément de commutation (31) d'un demi-pont (2) et la fermeture d'un second élément de commutation (32) du demi-pont (2),
le demi-pont (2) étant un élément d'un onduleur (10) qui convertit l'énergie électrique fournie par une source de tension continue en une tension alternative et la fournit à une machine électrique d'un véhicule à moteur,
avec
un système de commande (11) qui est formé pour piloter le demi-pont (2) de telle manière que le second élément de commutation (32) du demi-pont (2) est fermé après un temps mort après l'ouverture du premier élément de commutation (31) ; et
un système de détermination de température (12), qui est formé pour déterminer une température d'au moins un des éléments de commutation (31, 32) ;
le système de commande (11) étant formé pour
placer l'onduleur (10) dans un mode de fonctionnement dans lequel aucun couple de rotation n'est généré sur les roues motrices et la commutation continue des éléments de commutation (31, 32) est rendue possible,
réduire le temps mort d'un cycle de commutation par rapport au temps mort d'un cycle de commutation précédent, le système de détermination de température (12) étant formé pour déterminer la température d'au moins un des éléments de commutation (31, 32) après la réduction du temps mort,
le système de commande (11) et le système de détermination de température (12) étant formés pour répéter la réduction du temps mort et la détermination de la température pour des cycles de commutation suivants jusqu'à atteindre un temps mort critique auquel une condition d'arrêt est remplie qui dépend de la température déterminée ;
et le système de commande (11) étant formé pour régler le temps mort en tenant compte du temps mort critique.

12. Dispositif (1) selon la revendication 11, le système de détermination de température (12) comprenant un capteur (13) de mesure de courants et/ou de tensions électriques sur des sorties de l'élément de commutation respectif.

13. Dispositif (1) selon l'une des revendications 11 ou 12, le système de commande (11) étant formé pour définir la température (T) de l'élément de commutation (31, 32) à l'aide des courants et tensions électriques mesurés et d'une courbe caractéristique spécifiée de l'élément de commutation (31, 32) respectif.

14. Onduleur (10), avec une pluralité de demi-ponts (2), qui comportent chacun deux éléments de commutation (31, 32), et un dispositif (1) selon l'une des revendications 11 à 13 pour régler des temps morts entre l'ouverture et la fermeture d'éléments de commutation (31, 32) respectifs des demi-ponts (2).
